# EUROPEAN PATENT APPLICATION

(11) **EP 0 644 584 A1**
(43) Date of publication of application: **22.03.1995**
(21) Application number: 94114728.2
(22) Date of filing: 19.09.1994
(51) Int. Cl.: H01L 21/311, C23F 1/12

(54) **Improvement on selectivity in etching an oxidation film in a method for fabricating a semiconductor device**

(30) Priority: 17.09.1993 JP 230628/93
(71) Applicant: NEC CORPORATION, Tokyo (JP)
(72) Inventor: Akimoto, Takeshi, c/o NEC Corporation, Minato-ku, Tokyo (JP)
(74) Representative: Glawe, Delfs, Moll & Partner

(57) **Abstract**

In a step of forming a through-hole through an oxidation film in dry-etching the oxidation film by using fluorocarbon, a deposition film is formed on an etching surface to include carbon of more than 50%, preferably 80%, and fluorine of less than 50%, preferably 20%. Thus, a high selectivities to silicon, silicon nitride and titanium nitride are obtained.

## Description

### FIELD OF THE INVENTION

The invention relates to a method for fabricating a semiconductor device, and more particularly to, the improvement on selectivity in etching an oxidation film in a method for fabricating a semiconductor device.

### BACKGROUND OF THE INVENTION

One of conventional processes for etching an oxidation film in the fabrication of a semiconductor device is a dry-etching process in which fluorocarbon gas is used. As the fluorocarbon gas, carbon quaternary-fluoride, methane trifluoride, mixed gas of these gases, or the mixed gas added with argon, oxygen, hydrogen, etc. is used.

Selectivity to a under layer is important in the oxidation film etching process. As the under layer, silicon, silicon nitride, titanium nitride, etc. are used. Such selective etching to silicon is described on page 1585 of "J. Vac. Sci. Technol. A5(4), July/August, 1987". In this report, it is explained that in a dry-etching process of an oxidation film using fluorocarbon gas, a deposition film formed from carbon and fluorine is deposited to provide a selectivity in accordance With the suppression of etching. On the contrary, it is explained that the suppression of etching is hindered due to the removal of the deposition film caused by the reaction of carbon and oxygen contained in the film. Further, it is reported that the selectivity is largely dependent on the deposition film thickness, so that a high selectivity is obtained as a thickness of the deposition film is large.

As explained above, it is known that a fluorocarbon film composed of carbon and fluorine functions as a key factor in the selective etching of an oxidation film.

Another conventional etching process is described in the Japanese Patent Kokai No. 3-163824 in which an organic substance including no-saturated bond is added in the etching of an oxidation film, and the organic substance is deposited on the surface of silicon, so that the etching thereof is avoided.

However, the former conventional process for etching an oxidation film has a disadvantage in that a selectivity to silicon is not obtained to be sufficiently high, and it is practically approximately 20. On the other hand, the selectivity is approximately only 2 to silicon nitride, and only 4 to titanium nitride. In this manner, it is impossible that a high selectivity is obtained in the etching of an oxidation film on which a deposition film including fluorine of more than 50% is deposited.

### SUMMARY OF THE INVENTION

Accordingly, it is an object of the invention to provide a method for fabricating a semiconductor device in which a high selectivity is obtained in the etching of an oxidation film.

According to the invention, a method for fabricating a semiconductor device, comprises the step of:
depositing a deposition film on an etching surface of the oxidation film and a surface of a layer under the oxidation layer in plasma, the deposition film including carbon of more than 50% and fluorine of less than 50%.

In the conventional process for etching an oxidation film, a content of fluorine in a fluorocarbon film generated in plasma is more than 50%. For such a deposition film, a sputtering speed is high, and a sufficient thickness is not obtained on the surface of a under layer, so that a sufficient value is not obtained in regard to a selectivity to silicon, as being approximately 50. Further, selectivities are as low as 2 to a silicon nitride film, and 4 to a titanium nitride film.

In the invention, a content of carbon in a deposition film is more than 50%, preferably more than 90%, and that of fluorine is less than 50%, preferably less than 20%. By using an etching gas and gas plasma, a high selectivity in etching an oxidation film is obtained. In a deposition film having a large carbon content, a sputtering speed is low, and a sufficient thickness is obtained on the surface of a under layer during an etching stage, so that a high selectivity is obtained.

In order to provide a carbon-rich fluorocarbon film in which a high selectivity is realized, there is two methods as explained below.

The first method is that carbon monoxide CO is added to fluorocarbon gas. In accordance with the addition of CO, CF₂ which is considered to be deposition seed is diluted, and CO and F are reacted to compose COF or COF₂, so that fluorine is removed from plasma.

The second method is to use a high density plasma in which the dissolving of the etching gas is accelerated to remove fluorine from fluorocarbon gas, so that deposition seed mainly including carbon is obtained.

In accordance with the generation of a carbon-rich deposition film, a sputtering speed is low, and the protection of a under layer from the etching of an oxidation film is effectively carried out. Further, carbon reacts on the oxidation film with oxygen included in the oxidation film to compose CO or CO₂, so that the oxidation film is etched to be removed to provide no deposition film thereon, while the above described reaction never occurs on silicon, a silicon nitride film and a titanium nitride film including no oxygen. As a result, a selectivity in etching the oxidation film is remarkably increased as compared to the conventional process for etching an oxidation film.

### BRIEF DESCRIPTION OF THE DRAWINGS

The invention will be explained in more detail in conjunction with appended drawings, wherein:
Fig. 1 is a graph showing an XPS (X-ray photoemission spectroscopy) analysis result of a deposition film obtained in an etching plasma to he used in the invention;
Fig. 2 is a graph showing an etching speed of an oxidation film and a selectivity to silicon dependent on a mixing ratio of CO in accordance with the implementation of the invention;
Figs. 3A to 3C are cross-sectional views showing a method for fabricating a semiconductor device in a preferred embodiment according to the invention;
Figs. 4A and 4B are cross-sectional views showing a method for fabricating a semiconductor device in a further preferred embodiment according to the invention;
Fig. 5 is a cross-sectional view showing a conventional process for etching an oxidation film to provide a through-hole in a semiconductor device; and
Figs. 6A and 6B are a cross-sectional view showing a high density plasma source, and a plan view showing an electrode of the plasma source, respectively, used in the invention.

### DESCRIPTION OF THE PREFERRED EMBODIMENTS

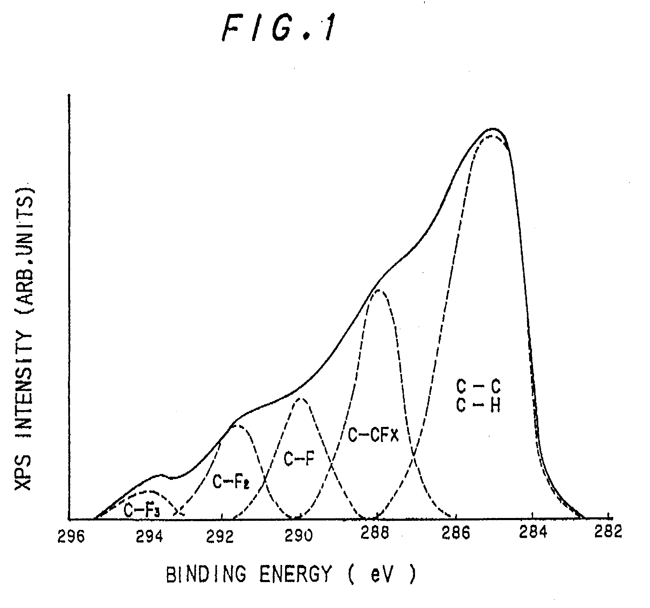

Fig. 1 shows the XPS analysis result of a deposition film formed in plasma in a high selectivity-etching of an oxidation film, wherein a silicon substrate having a deposition film thereon is introduced in plasma, and plasma radiation is carried out to analyze the deposition film by using the XPS. The first etching conditions are that an etching apparatus in which a high selectivity is realized in the etching of an oxidation film is a magnetron reactive ion etching (MRIE) apparatus, and mixed gas of CHF₃ and CO is used as an etching gas. In the first etching conditions, a gas flow amount of CHF₃ is 10sccm (standard cubic centimeters per minute), that of CO is 100sccm, an etching pressure is 40mTorr, and a high frequency electric power is 600W.

As understood from Fig. 1, a peak caused by C-C bond is dominant in a signal of C1s for a deposition film formed in the plasma, and other peaks caused by C-F₂, C-F₃, and C-CFx (X = 1, 2 or 3) are observed. It is concluded as a result of the calculation for proportion of carbon and fluorine in accordance with the signal that carbon is 60% and fluorine is 40%. In the etching of the oxidation film, a selectivity to silicon is obtained to be 60.

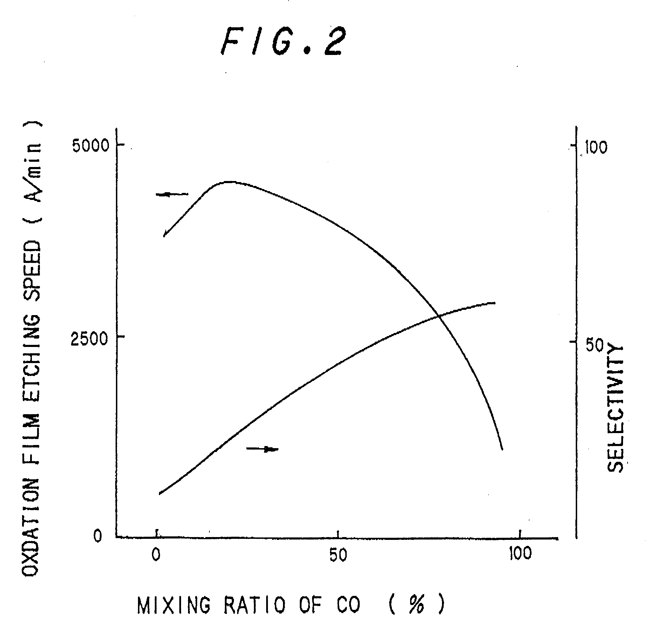

Fig. 2 shows an etching speed of an oxidation film and a selectivity to silicon in case of changing a mixing ratio of CO. The maximum etching speed is 4000Å/min, and the etching speed is decreased as the mixing ratio of CO is increased. On the other hand, the selectivity is increased to silicon an the mixing ratio of CO is increased, wherein it is 60 when a mixing ratio of CO is 90%, and the selectivities to silicon nitride and to titanium nitride are 20 and 10 at the same mixing ratio, respectively.

The second etching conditions are that C₂F₆, C₃F₈ or C₄F₈ is used in place of CHF₃ in the first etching conditions. As a result, the same or more advantageous result is obtained, wherein a selectivity is increased as a mixing ratio of CO is increased. In more detail, a selectivity is approximately 60 to silicon. This is substantially the same as in the first etching conditions. However, a selectivity is increased as much as twice to silicon nitride and titanium nitride in case of using C₂F₆, C₃F₈ or C₄F₈ as compared to the first etching conditions.

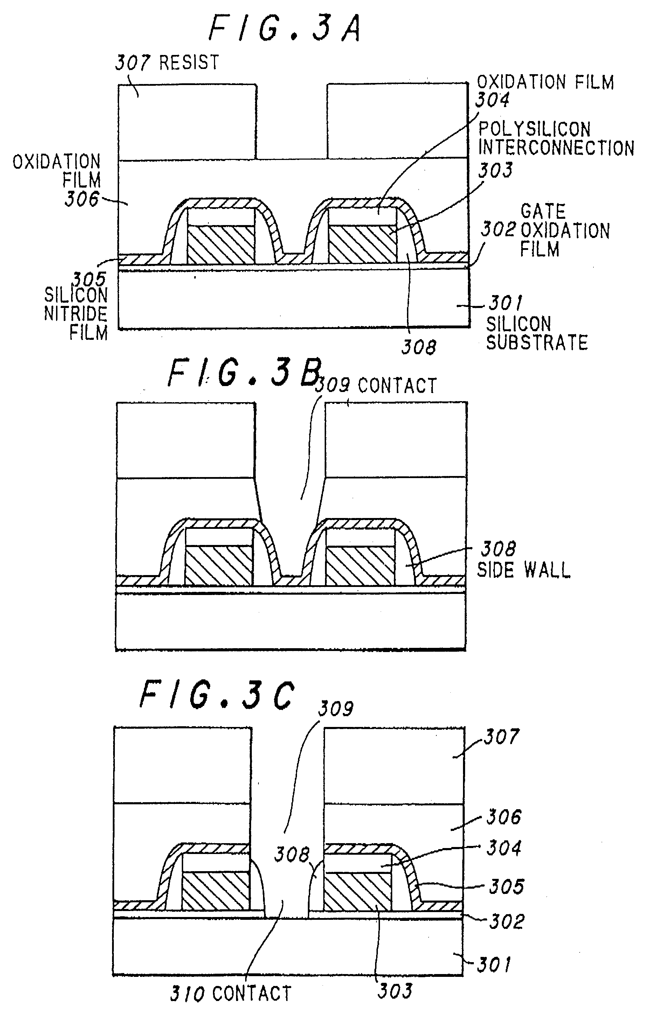

Figs. 3A to 3C show a method for fabricating a semiconductor substrate in a preferred embodiment according to the invention, wherein the second etching conditions are adopted.

In Fig. 3A, a gate oxidation film 302 is formed on a silicon substrate 301 by the thermal oxidation method, and a polysilicon interconnection 303 and an oxidation film 304 are successively formed on the gate oxidation film 302 Then, the interconnection 303 and the film 304 are patterned, and covered with side walls 308 of oxidation films. Then, a silicon nitride film 305 for self-alignment stopper and an interfacial insulating film 306 of oxidation film are formed. Thereafter, a resist 307 which is a mask for forming a contact is formed by the lithography process.

In Fig. 3B, the etching of the oxidation film 306 is stopped at the silicon nitride film 305 in accordance with the formation of a deposition film by a high selectivity as explained in the second etching conditions. In this preferred embodiment, the MRIE apparatus is used by using mixed gas of C₄F₆ and CO. As described before, the other conditions are that a flowing amount of C₄F₆ is 10sccm, that of CO is 100sccm, an etching pressure is 40mTorr, and a high frequency electric power is 600W. Under these conditions, an etching speed of the oxidation film 306 is 4500Å/min, and a selectivity to the silicon nitride film 305 is obtained as high as 40. In accordance with this etching, a contact 309 is self-aligned to be formed as illustrated in Fig. 3B.

In Fig. 3C, a contact 310 is apertured by etching the silicon nitride film 305 and the gate oxide film 302.

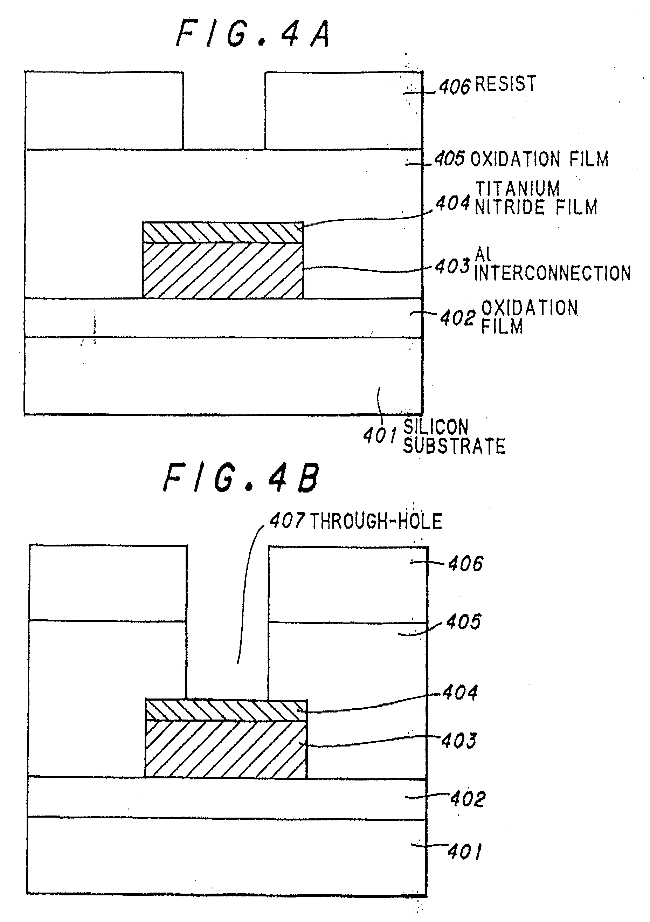

Figs 4A and 4B show a method for fabricating a semiconductor device in a further preferred embodiment according to the invention, wherein the second etching conditions are used.

In Fig. 4A, an oxidation film 402 is formed on a silicon substrate 401 by the CVD method, and an Al interconnection 403 is formed thereon. Then, a titanium nitride 404 for an AR (anti-reflection) film is formed on the Al interconnection 403 by the lithography process, and the Al interconnection 403 and the silicon nitride film 404 are simultaneously patterned. Then, an oxidation film 405 for an interfacial insulating film is deposited by the CVD method, and a resist 406 which is a mask for forming a through-hole is formed thereon by the lithography process.

In Fig. 4B, the etching of the oxidation film 405 is stopped at the titanium nitride film 404 to provide a through-hole 407.

In this further preferred embodiment, the MRIE apparatus is used by using mixed gas of C₄F₆ and CO, as explained before. The remaining conditions are also the same as in the former preferred embodiment. Under these conditions, an etching speed of the oxidation film 405 is 4500Å/min, and a selectivity is obtained as high as 20 to the titanium nitride film 404.

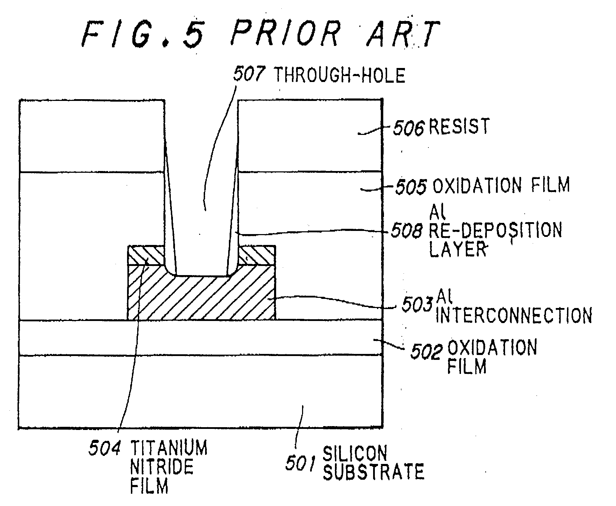

Fig. 5 shows a semiconductor device which is fabricated by using a conventional etching process in which a selectivity is as low as 4 to a titanium nitride film 504. In accordance with the low selectivity, the titanium nitride film 504 is etched during the etching to provide a through-hole 507. Consequently, a re-deposition layer 508 of Al is deposited on side walls of the through-hole 507 to lower an electric resistance of the through-hole 507 and a yield of semiconductor devices. In Fig. 5, the reference numeral 501 indicates a silicon substrate, 502 an oxidation film, 503 an Al interconnection, 505 an oxidation film, and 506 a resist.

In the preferred embodiments, mixed gas of methane quaternary fluoride and hydrogen may be used as a reactive gas, and an etching pressure is 30mTorr. When mixed gas of CF₄ and H₂ is used by a mixing ratio of H₂ which is more than 60%, the same result is obtained as in the preferred embodiments. That is, a deposition film formed in plasma is made as a carbon-rich film to provide a selectivity of 60 to silicon, 20 to silicon nitride, and 10 to titanium nitride.

Here, a gas flowing amount of CHF₃ is 10sccm, that of CO is 10sccm, an etching pressure is 30mTorr, and a high frequency electric power is 600W.

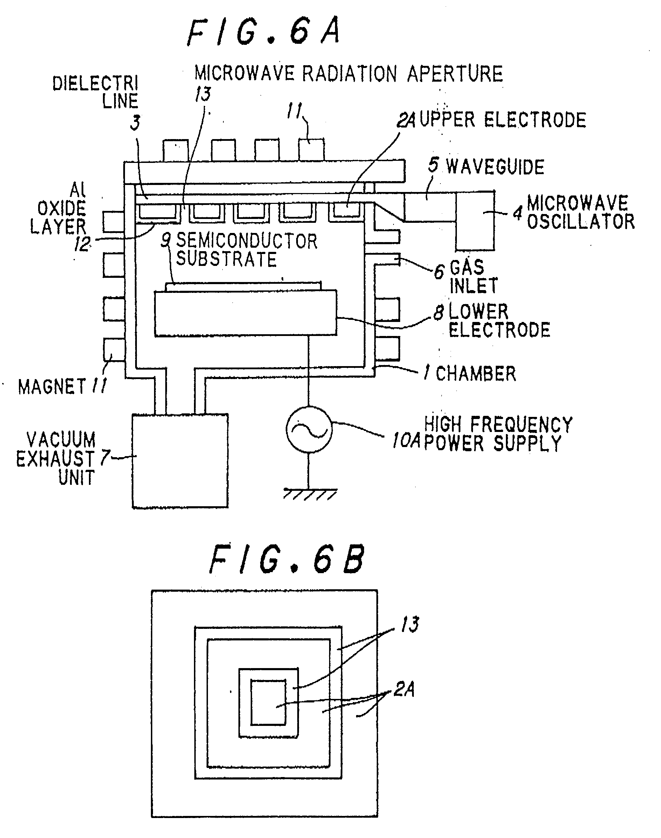

Fig. 6A shows a high density plasma source which is preferable to be used in the invention, The use of the high density plasma source enhances the effectiveness of the invention.

The MRIE apparatus used in the preferred embodiments provides a plasma density of approximately 5 x 10¹⁰cm⁻³. On the other hand, the high density plasma source as shown in Fig. 6A provides a plasma density of 5 x 10¹²cm⁻³, in which the dissolving of fluorocarbon used as an etching gas is accelerated to provide a carbon-rich deposition film. Further, a high etching speed is obtained to improve a through-put in the high density plasma source.

In Fig. 6A, the high density plasma source comprises a lower electrode 8 for placing a semiconductor substrate 9 thereon in a chamber 1, upper electrodes 2A also provided in the chamber 1, a dielectric line 3 of a teflon plate connected via a waveguide 5 to a microwave oscillator 4, a high frequency power supply 10A connected to the lower electrode 8, a gas inlet 6 for supplying an etching gas to the inside of the chamber 1, magnets 11 provided on the outside of the chamber 1, and a vacuum exhaust unit 7 for providing vacuum in the chamber 1. As shown in Fig. 6B, microwave radiation apertures 13 are defined by interstices of the upper electrodes 2A which are covered with aluminum oxide layers 12.

In operation, microwaves transmitted via the waveguide 5 from the microwave oscillator 4 are supplied to the dielectric line to be transmitted in a transverse direction. Thus, an electric field of a uniform strength is obtained in the transverse direction, and a VSWR wave is generated in the transmitting (longitudinal) direction. The microwaves in the inside of the dielectric line 3 are radiated from the radiation apertures 13 to generate high density plasma. Thus, a uniform plasma having a density of 5 x 10¹²cm⁻³ is obtained on the semiconductor substrate 9. In accordance with the use of the plasma thus generated, the dissolving of fluorocarbon used as an etching gas is accelerated to provide a carbon-rich deposition film. As described before, a high etching speed and a high through-put are obtained by using the high density plasma.

Although the invention has been described with respect to specific embodiment for complete and clear disclosure, the appended claims are not to be thus limited but are to be construed as embodying all modification and alternative constructions that may be occur to one skilled in the art which fairly fall within the basic teaching here is set forth.

## Claims

1. In a method for fabricating a semiconductor device in which an oxidation film is dry-etched to provide a hole therethrough by using fluorocarbon gas,
said method, comprising the step of:
depositing a deposition film on an etching surface of said oxidation film and a surface of a layer under said oxidation layer in plasma, said deposition film including carbon of more than 50% and fluorine of less than 50%.

2. A method for fabricating a semiconductor device, according to claim 1, wherein;
said fluorocarbon gas is mixed gas of methane trifluoride and carbon monoxide, a mixing ratio of said carbon monoxide being more than 80%.

3. A method for fabricating a semiconductor device, according to claim 1, wherein:
said fluorocarbon gas is mixed gas of methane quaternary-fluoride and carbon monoxide, a mixing ratio of said carbon monoxide being more than 80%.

4. A method for fabricating a semiconductor device, according to claim 1, wherein:
said fluorocarbon gas is mixed gas of one selected from ethane fluoride, propane fluoride and butane fluoride, and carbon monoxide, a mixing ratio of said carbon being more than 80%.

5. A method for fabricating a semiconductor device, according to claim 1, wherein:
said plasma has a density of more than 5 x 10¹²cm⁻³.
